# EUROPÄISCHE PATENTSCHRIFT

(11) **EP 0 472 919 B1**
(45) Veröffentlichungstag und Bekanntmachung des Hinweises auf die Patenterteilung: **18.12.1996**
(21) Anmeldenummer: 91112568.0
(22) Anmeldetag: 26.07.1991
(51) Int. Cl.: H03K 17/18, H03K 17/95

(54) **Elektronisches, vorzugsweise berührungslos arbeitendes Schaltgerät**
Electronic switching device, preferably operating without contact
Appareil de commutation électronique, fonctionnant de préférence sans contact

(30) Priorität: 30.08.1990 DE 4027387
(43) Veröffentlichungstag der Anmeldung: 04.03.1992
(73) Patentinhaber: Werner Turck GmbH & Co. KG, D-58553 Halver (DE)
(72) Erfinder: Tigges, Burkhard, W-5983 Balve 2 (DE); Sowa, Herbert, O-9430 Schwarzenberg (DE)
(74) Vertreter: Peerbooms, Rudolf, Dipl.-Phys.

(56) Entgegenhaltungen:
- WO-A-86/03079
- DE-A- 3 139 042
- DE-A- 3 731 774
- GB-A- 2 135 840

## Beschreibung

Die Erfindung betrifft ein elektronisches, vorzugsweise berührungslos arbeitendes Schaltgerät nach dem Oberbegriff des Anspruches 1.

Ein gattungsgemäßes Schaltgerät ist durch die Druckschrift "IC FOR PROXIMITY DETECTOR FM 303", 09.05.1988, der Firma Favag SA Microelectronics, Schweiz, bekannt. Dort wird das Sensorsignal eines von außen verstimmbaren Oszillators einer Auswertestufe zugeführt, die zwei im Gegentakt arbeitende Treiberstufen ansteuert. Zusätzlich schaltet die Auswertestufe einen LED-Treiber mit besonderem LED-Ausgang, an den eine LED zur Anzeige des Schaltzustandes unmittelbar anschließbar ist. Eine Kurzschluß-Abfrageeinrichtung schaltet bei einem Kurzschluß im Lastkreis nur die beiden Treiberstufen zum Schutz der gesamten Schaltung intervallweise ab. Als Nachteil erweist sich dabei, daß die LED, die von der Auswertestufe geschaltet wird, auch bei Kurzschluß nach wie vor das Ansteuersignal für die Treiberstufen anzeigt und keinen Rückschluß auf den tatsächlich vorliegenden Kurzschluß zuläßt.

Aus der Druckschrift SIEMENS IS-SPEZIFIKATION S594 vom 22.04.1986 ist ferner ein Schaltgerät bekannt, das mit dem IC "TCA 505" der "Siemens AG" aufgebaut ist. Bei diesem IC werden von den beiden Treiberstufen jeweils IC-interne Ausgangstransistoren mit offenen Kollektoren bzw. offenen Emittern angesteuert. Aus der Beschreibung dieses IC's ist bekannt, eine LED zur Anzeige des Schaltzustandes zwischen Versorgungsspannung und einem offenen Emitter zwischenzuschalten. Diese LED zeigt das Vorliegen eines Kurzschlusses im Laststromkreis durch schwaches Pulsieren an, da von der Kurzschluß-Abfrageeinrichtung beide Treiberstufen kurzzeitig zur Abfrage des Kurzschlusses eingeschaltet werden. Dabei besteht die Gefahr, daß bei hohen Schaltfrequenzen des Schaltgerätes Verwechslungen auftreten können. Das dortige IC benötigt insgesamt vier Treiberstufen-Ausgänge, die immer IC-extern beschaltet sein müssen, um die Funktion sicherzustellen, und ist damit aufwendig. Darüber hinaus ist eine Begrenzung der Basisspannung der internen Ausgangstransistoren vorgesehen, wozu ein weiterer IC-Anschluß nötig ist und die Ausgangstransistoren IC-intern miteinander verkoppelt sind.

Aus der DE-OS 37 31 774 ist das Blockschaltbild eines Schaltgerätes bekannt, bei dem für die Anzeige des Schaltzustandes und für die Anzeige eines Kurzschlusses eine gemeinsame Leuchtdiode verwendet ist. Eine Schaltstufe schaltet sowohl die Leuchtdiode als auch den Lastschalter, und wird im Kurzschlußfall derart von einer Kurzschluß-Abfrageeinrichtung angesteuert, daß der Kurzschlußfall durch Blinken angezeigt wird. Auch dort steht kein für sich abgreifbares Signal zur eindeutigen Kennzeichnung des Kurzschlusses zur Verfügung, so daß eine eindeutige Unterscheidung zwischen Kurzschluß und der Anzeige des Schaltzustandes nicht immer gewährleistet ist.

Aus der DE-OS 34 41 403 ist ein mittels diskreter Bauteile aufgebautes Schaltgerät bekannt, das eine einzige LED zur Anzeige des Schaltzustandes und eines Kurzschlusses aufweist, die im Kurzschlußfall mit einer bestimmten Frequenz blinkt. Wegen des Aufbaus aus diskreten Bauteilen können dort zwar eindeutige Anzeigen für den Schaltzustand und den Kurzschlußfall gewonnen und kundenspezifische Wünsche erfüllt werden, aber bei gattungsgemäßen Schaltgeräten, die über ein IC verfügen, können Sonderwünsche eines Kunden höchstens durch eine aufwendige, äußere Beschaltung des IC's erfüllt werden, da die Herstellung jeweils unterschiedlich integrierter Schaltkreise viel zu teuer käme.

Der Erfindung liegt die Aufgabe zugrunde, ein berührungslos arbeitendes Schaltgerät mit einer integrierten Schaltung auszurüsten, die Anzeigesignale für den "Betriebszustand", den "Schaltzustand" und den "Kurzschlußfall" zur Verfügung stellt, die ohne besonderen Schaltungsaufwand nur durch entsprechende LED-Bestückung des Schaltgerätes - je nach Kundenwunsch in unterschiedlichster Kombination - zur Anzeige gebracht werden können.

Ausgehend von einem gattungsgemäßen Schaltgerät ist diese Aufgabe erfindungsgemäß dadurch gelöst, daß die integrierte Schaltung IC an einem weiteren IC-Ausgang ein pulsierendes Signal für die Anzeige eines Kurzschlusses liefert, an den unmittelbar eine Kurzschluß-Anzeige LED anschließbar ist, so daß unter Mitbenutzung eines der Speisespannungs-IC-Anschlüsse und der beiden IC-Ausgänge das IC für alle Zustände "Schaltzustand"," Kurzschluß" und "Betrieb" wahlweise entweder mit drei LED oder mit zwei LED's beschaltet ist, wobei im letzteren Fall die an den weiteren IC-Ausgang anschließbare LED entweder sowohl den Kurzschluß als auch den Schaltzustand gleichzeitig oder sowohl den Kurzschluß als auch den Betrieb gleichzeitig anzeigt.

Durch die Erfindung ist es ermöglicht, mit nur einem IC eine Vielzahl von hinsichtlich der Anzeigen unterschiedlichen Ausführungsformen von Näherungsschaltern zu fertigen, die auf einer Platine vorgefertigt werden können und je nach Kundenwunsch mit der geforderten Anzeigeeinrichtung nachbestückt werden. Durch Verzicht auf die eine oder andere Anzeige können auch alle diesbezüglich in Frage kommenden Kundenwünsche erfüllt werden.

In Ausgestaltung der Erfindung kann ferner vorgesehen werden, daß die beiden Treiberstufen untereinander elektrisch entkoppelt sind, daß eine der beiden Treiberstufen IC-intern mit beiden Speisespannungs-Anschlüssen verbunden ist, daß die zweite Treiberstufe nur mit einem Speisespannungs-Anschluß IC-intern verbunden und über den IC-Ausgang, an dem das Signal für den Schaltzustand abnehmbar ist, IC-extern an die Versorgungsspannung anschließbar ist und daß ferner die Kurzschluß-Abfrageeinrichtung im Kurzschlußfall einen Taktgenerator einschaltet, der mit vergleichsweise niedriger Frequenz die Stromquelle eines LED-Treibers einschaltet, wodurch am IC-Ausgang für das Kurzschlußsignal ein getaktetes, zur Anzeige des Kurzschlußfalls geeignetes Signal zur Verfügung steht.

Gemäß einer ersten Ausführungsform kann vorgesehen sein, daß zwischen dem IC-Ausgang für den Kurzschluß und einem Pol der Versorgungsspannung unmittelbar eine LED als Kurzschlußanzeige angeordnet ist, daß zwischen dem Pol der Versorgungsspannung und dem IC-Ausgang für den Schaltzustand zwei LED's hintereinandergeschaltet sind, wobei ein zwischen den LED's liegender Verteilerpunkt mit einem Speisespannungsanschluß verbunden ist, und daß die direkt an den Pol der Versorgungsspannung angeschlossene LED den Betrieb des Schaltgerätes und die direkt an den IC-Ausgang für den Schaltzustand angeschlossene LED den Schaltzustand des Lastschalters anzeigt. In Weiterbildung können die den Kurzschluß anzeigende LED und die den Betrieb anzeigende LED in einer Doppel-LED mit gemeinsamer Kathode bzw. Anode entsprechend der vorgesehenen Speisespannungspolarität zusammengefaßt sein, so daß ein Kurzschluß durch eine aufblinkende Mischfarbe im Wechsel mit der den normalen Betrieb anzeigenden LED-Farbe angezeigt wird. Hierbei ist eine eindeutige Kennzeichnung aller zu erfassenden Zustände einschließlich "Betriebszustand" durch nur zwei LED-Anzeigeeinrichtungen ermöglicht.

Eine zweite Ausführungsform des Schaltgerätes nach der Erfindung ist dadurch gekennzeichnet, daß zwischen einem Pol der Versorgungsspannung und dem IC-Ausgang für den Schaltzustand zwei LED's hintereinandergeschaltet sind, wobei ein zwischen den LED's liegender Verteilerpunkt mit einem Speisespannungs-Anschluß und dem IC-Ausgang für den Kurzschluß verbunden ist, daß die direkt an den Pol angeschlossene LED den Betrieb des Schaltgerätes anzeigt, daß die direkt an den IC-Ausgang für den Schaltzustand angeschlossene LED den Schaltzustand anzeigt und daß ein Kurzschluß durch ein Pulsieren der auch den Betrieb anzeigenden LED mit der Frequenz des Taktgenerators angezeigt wird.

Bei einer dritten Variante des Schaltgerätes nach der Erfindung ist vorgesehen, daß zwischen einem Pol der Versorgungsspannung und einem Speisespannungs-Anschluß eine erste LED als Betriebsanzeige geschaltet ist, daß eine zweite LED einerseits an den Pol der Versorgungsspannung und andererseits an den IC-Ausgang zur Anzeige des Schaltzustandes und an den IC-Ausgang für Kurzschluß angeschlossen ist, so daß die zweite LED durch Blinken mit der Frequenz des Taktgenerators einen Kurzschlußfall anzeigt.

Bei beiden letztgenannten Ausführungsformen werden alle Zustände eindeutig durch nur zwei LED's angezeigt. Von besonderem Vorteil erweist es sich, daß alle drei beschriebenen Schaltgeräte auf einer einzigen Platine aufgebaut werden können, die bis auf die Anzeige-LED's fertig bestückt und auf Vorrat gehalten werden kann. Entsprechend den Wünschen eines Kunden können diese Platinen dann mit der notwendigen Anzahl der LED's bzw. speziellen LED-Typen bestückt werden. Eine weitere Beschaltung des IC's zum Erzielen spezieller Anzeigearten beschränkt sich auf die Verbindung von Verteilerpunkten mit entsprechenden IC-Anschlüssen, was durch einfache Drahtbrücken erreicht wird.

Der Gegenstand der Erfindung wird im folgenden anhand der Zeichnung näher erläuert. In der Zeichnung zeigen:
- Fig. 1: eine erste Ausführungsform eines Schaltgerätes nach der Erfindung, bei der für jeden zu erfassenden Zustand eine gesonderte Anzeige-LED vorgesehen ist,
- Fig. 2: eine zweite Ausführungsform, bei der die "Betriebsanzeige"-LED" auch zur Anzeige eines Kurzschlusses verwendet ist, und
- Fig. 3: eine dritte Ausführungsform, bei der die "Schaltzustand"-Anzeige-LED zugleich zur Anzeige eines Kurzschlusses genutzt ist.

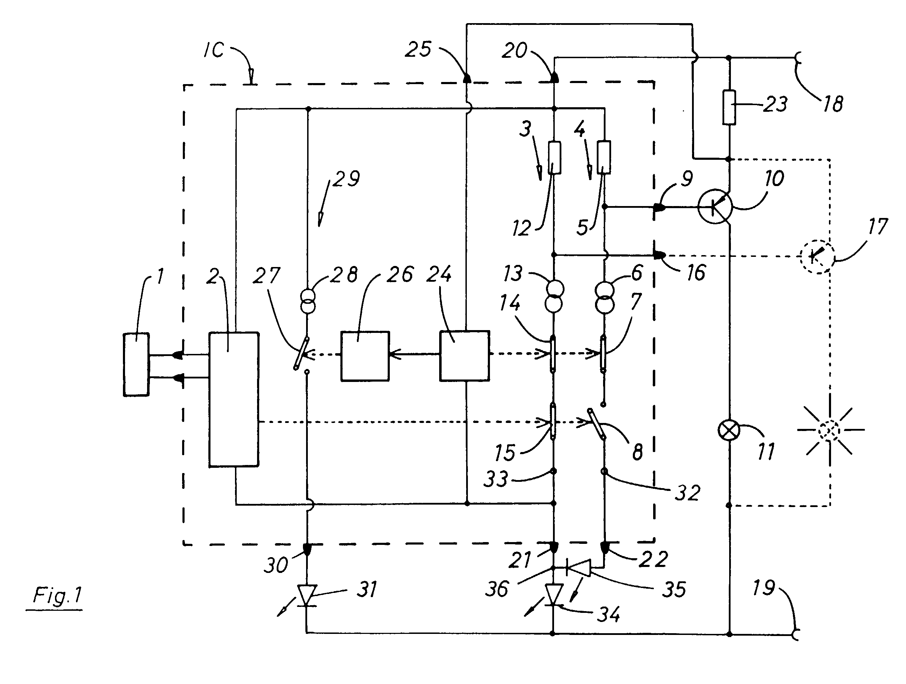

Bei dem Schaltgerät nach Fig. 1 wird das Sensorsignal eines Sensors 1 einer integrierten Schaltung IC zugeführt und dort von einer Auswertestufe 2 aufbereitet, die zwei im Gegentakt arbeitende Treiberstufen 3 und 4 ansteuert. Die Einzelschaltkreise der integrierten Schaltung IC sind in der Zeichnung vereinfacht durch elektrotechnische Symbole wie Unterbrecher, Schalter und Stromquelle wiedergegeben. Die Treiberstufe 4, dargestellt als aus einem Widerstand 5, einer Stromquelle 6, einem Unterbrecher 7 und einem Schalter 8 bestehend, steuert über einen IC-Ausgang 9 einen Lastschalter 10, bei dem es sich beispielsweise um einen Transistor handeln kann. In der gezeigten Grundstellung ist der Schalter 8 offen und somit die Last 11 nicht eingeschaltet. Bei der im Gegentakt arbeitenden Treiberstufe 3, die einen Widerstand 12, eine Stromquelle 13, einen Unterbrecher 14 und einen Schalter 15 umfaßt, wird der Schalter 15 im Gegentakt zum Schalter 8 geöffnet bzw. geschlossen, während der Unterbrecher 14 gleichsinnig wie der Unterbrecher 7 arbeitet. Von der Treiberstufe 3 kann am IC-Ausgang 16 ein Steuersignal für einen, in der Regel nicht vorgesehenen weiteren Lastschalter 17 abgegriffen werden. An die Pole 18, 19 der Versorgungsspannung ist die integrierte Schaltung IC über zwei Speisespannungs-Anschlüsse 20, 21 angeschlossen, an die IC-intern, mit Ausnahme der zweiten Treiberstufe 4, alle Einzelschaltkreise angeschlossen sind.

Ein Kurzschluß im Lastkreis kann durch Überwachung des Spannungsabfalls an einem Meßwiderstand 23 von einer in der Schaltung IC enthaltenden Kurzschluß-Abfrageeinrichtung 24 festgestellt werden, die über einen IC-Eingang 25 parallel zu dem den Lastschalter 10 und die Last 11 enthaltenden Lastkreis geschaltet ist. Überschreitet der Laststrom einen Maximalwert, bewirkt die mit hoher Frequenz arbeitende Abfrageeinrichtung 24 periodisch ein öffnen beider Unterbrecher 7, 14, wodurch die Treiber- bzw. Laststromkreise unterbrochen werden. Gleichzeitig schaltet die Kurzschluß-Abfrageeinrichtung 24 einen mit vergleichsweise geringer Blinkerfrequenz arbeitenden Taktgenerator 26 ein. Dieser schließt mit der Blinkerfrequenz über einen Schalter 27 eine Stromquelle 28 eines LED-Treibers 29, so daß zwischen einem IC-Ausgang 30 und dem Pol 19 der Versorgungsspannung eine LED 31 zur Anzeige eines Kurzschlusses angeordnet werden kann, die von dem übrigen Schaltgerät völlig unabhängig ist.

Die Treiberstufen 3 und 4 sind IC-intern an einen Speisespannungs-Anschluß 20 und über diesen mit dem Pol 18 der Versorgungsspannung verbunden. Die Treiberstufe 4 ist an ihrer Anschlußseite 32 über einen eigenen IC-Ausgang 22 an den zweiten Pol 19 der Versorgungsspannung angeschlossen, während die Treiberstufe 3 an ihrer IC-internen Anschlußseite 33 mit dem Speisespannungs-Anschluß 21 verbunden ist. Zwischen dem Speisespannungs-Anschluß 21 und dem Pol 19 der Versorgungsspannung ist eine LED 34 zur Anzeige des Betriebes geschaltet. In Reihe zu der LED 34 liegt eine weitere LED 35, die an den IC-Ausgang 22 und einen Verteilerpunkt 36 angeschlossen ist, der zwischen dem IC-Speisespannungsanschluß 21 und der LED 34 liegt. Die LED 35 zeigt den Schaltzustand des Schaltgerätes an.

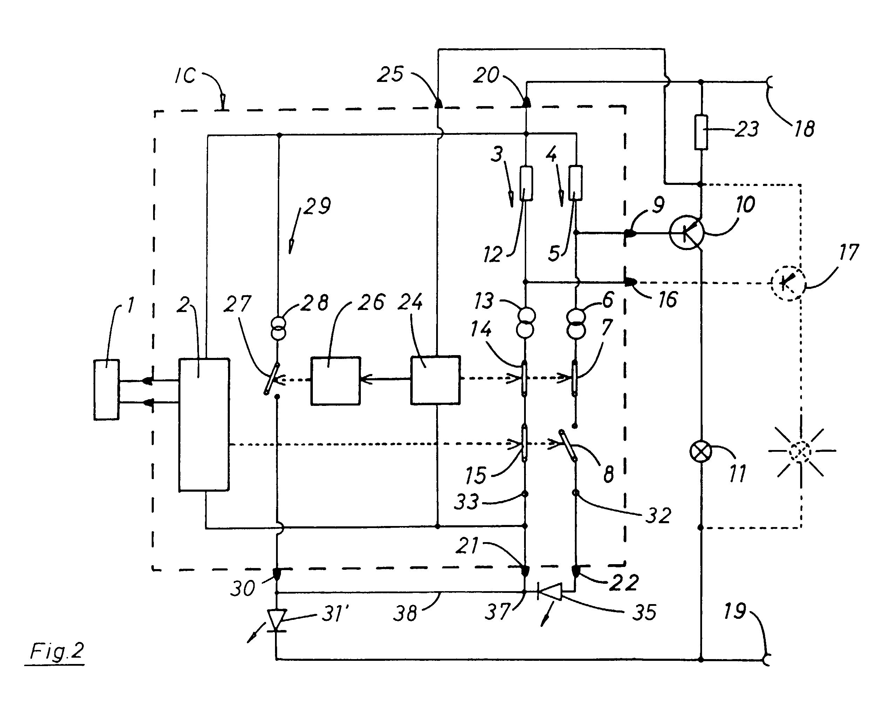

Beim Ausführungsbeispiel nach Fig. 2 sind eine LED 31' und die LED 35 zur Anzeige des Schaltzustandes zwischen dem IC-Ausgang 22 und dem Pol 19 hintereinandergeschaltet, wobei ein Verteilerpunkt 37 zwischen den LED's 31', 35 mit dem Speisespannungs-Anschluß und über eine Brücke 38 mit dem IC-Ausgang 30 verbunden ist. Die Stromversorgung der IC-Schaltung erfolgt hier über die LED 31', die somit auch den Betrieb anzeigt. Das im Kurzschlußfall am IC-Ausgang 30 anliegende Taktsignal verursacht ein Pulsieren der LED 31' mit der Blinkerfrequenz des Taktgenerators 26 und zeigt so einen Kurzschluß an.

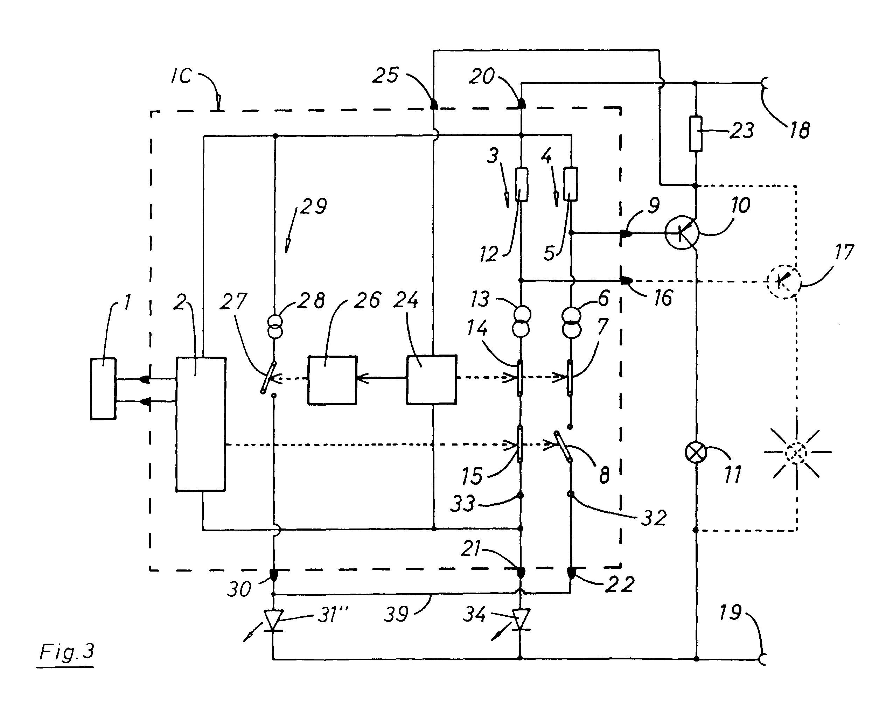

Beim Ausführungsbeispiel nach Fig. 3 ist der IC-Ausgang 22 über eine Brücke 39 mit dem IC-Ausgang 30 verbunden, wodurch bei normalem Betrieb die an den IC-Ausgang 30 und 22 sowie den Pol 19 angeschlossenen LED 31'' den Schaltzustand des Gerätes anzeigt, während sie, wie zuvor beschrieben, den Kurzschlußfall durch Blinken anzeigt. Eine Anzeige des Betriebes erfolgt bei diesem Ausführungsbeispiel wieder durch die LED 34, die zwischen den Speisespannungs-Anschluß 21 und Pol 19 geschaltet ist.

### Bezugszeichenliste

- 1: Sensor
- 2: Auswertestufe
- 3: Treiberstufe
- 4: Treiberstufe
- 5: Widerstand
- 6: Stromquelle
- 7: Unterbrecher
- 8: Schalter
- 9: IC-Ausgang
- 10: Lastschalter
- 11: Last
- 12: Widerstand
- 13: Stromquelle
- 14: Unterbrecher
- 15: Schalter
- 16: IC-Ausgang
- 17: Lastschalter
- 18: Anschlußpol der Versorgungsspannung
- 19: Anschlußpol der Versorgungsspannung
- 20: IC-Speisespannungs-Anschluß
- 21: IC-Speisespannungs-Anschluß
- 22: IC-Ausgang
- 23: Meßwiderstand
- 24: Kurzschluß-Abfrageeinrichtung
- 25: IC-Eingang
- 26: Taktgenerator
- 27: Schalter
- 28: Stromquelle
- 29: LED-Treiber
- 30: IC-Ausgang
- 31: Kurzschluß-Anzeige-LED
- 31': Kurzschluß-und Betriebs-Anzeige-LED
- 31": Kurzschluß-und Schaltzustand-Anzeige-LED
- 32: zweite Anschlußseite
- 33: zweite Anschlußseite
- 34: Betriebsanzeige-LED
- 35: Schaltzustand-Anzeige-LED
- 36: Verteilerpunkt
- 37: Verteilerpunkt
- 38: Brücke
- 39: Brücke

## Patentansprüche

1. Elektronisches, vorzugsweise berührungslos arbeitendes Schaltgerät, mit einem von außen beeinflußbaren Sensor (1), dessen Sensorsignal einer integrierten Schaltung, auch IC genannt, zugeführt wird, die zwei Speisespannungsanschlüsse (20, 21) zum Anschluß an die beiden Pole (18,19) einer Versorgungsspannung, eine Auswertestufe (2), zwei im Gegentakt arbeitende Treiberstufen (3, 4) zur Ansteuerung jeweils eines elektronischen Lastschalters (10,17) und eine Kurzschluß-Abfrageeinrichtung (24) als Schutzeinrichtung aufweist, und die ein Signal für den Schaltzustand eines der Lastschalter an einen IC-Ausgang (22) liefert, an welchen eine LED (35) für den Schaltzustand unmittelbar anschließbar ist, dadurch gekennzeichnet, daß die integrierte Schaltung IC an einem weiteren IC-Ausgang (30) ein pulsierendes Signal für die Anzeige eines Kurzschlusses liefert, an den unmittelbar eine Kurzschluß-Anzeige LED (31) anschließbar ist, so daß unter Mitbenutzung eines (21) der Speisespannungs anschlüsse (20,21), des IC-Ausgangs (22) und des weiteren IC-Ausgangs (30) das IC für die Anzeige aller Zustände "Schaltzustand", "Kurzschluß" und "Betrieb" wahlweise entweder mit drei LED's (31, 34, 35) oder mit zwei LED's (31',31",34,35) beschaltet ist, wobei im letzteren Fall die an der weiteren IC-Ausgang anschließbare LED (31",31') entweder sowohl den Kurzschluß als auch den Schaltzustand gleichzeitig oder sowohl den Kurzschluß als auch den Betrieb gleichzeitig anzeigt.

2. Schaltgerät nach Anspruch 1, dadurch gekennzeichnet, daß die beiden Treiberstufen (3, 4) untereinander elektrisch entkoppelt sind, daß eine (3) der beiden Treiberstufen (3, 4) IC-intern mit beiden Speisespannungs-Anschlüssen (20, 21) verbunden ist, daß die zweite Treiberstufe (4) nur mit einem Speisespannungs-Anschluß (20) IC-intern verbunden und über den IC-Ausgang (22), an dem das Signal für den Schaltzustand abnehmbar ist, IC-extern an die Versorgungsspannung anschließbar ist.

3. Schaltgerät nach den Ansprüchen 1 oder 2, dadurch gekennzeichnet, daß die Kurzschluß-Abfrageeinrichtung (24) im Kurzschlußfall einen Taktgenerator (26) einschaltet, der mit vergleichsweise niedriger Frequenz die Stromquelle (28) eines LED-Treibers (29) einschaltet, wodurch am weiteren IC-Ausgang (30) ein getaktetes, zur Anzeige des Kurzschlußfalls geeignetes Signal zur Verfügung steht.

4. Schaltgerät nach den Ansprüchen 1 bis 3, dadurch gekennzeichnet, daß zwischen dem weiteren IC-Ausgang (30) und dem einen Pol (19) der Versorgungsspannung unmittelbar eine LED (31) als Kurzschlußanzeige angeordnet ist, daß zwischen dem einen Pol (19) und dem IC-Ausgang (22) zwei LED's (34, 35) hintereinandergeschaltet sind, wobei ein zwischen den LED's (34, 35) liegender Verteilerpunkt (36) mit dem einen Speisespannungs-Anschluß (21) verbunden ist, und daß die direkt an den einen Pol (19) der Versorgungsspannung angeschlossene LED (34) den Betrieb des Schaltgerätes und die direkt an den IC-Ausgang (22) angeschlossene LED (35) den Schaltzustand des Lastschalters (10) anzeigt.

5. Schaltgerät nach Anspruch 4, dadurch gekennzeichnet, daß die den Kurzschluß anzeigende LED (31) und die den Betrieb anzeigende LED (34) in einer Doppel-LED mit gemeinsamer Kathode bzw. Anode entsprechend der vorgesehenen Speisespannungspolarität zusammengefaßt sind, so daß ein Kurzschluß durch eine aufblinkende Mischfarbe im Wechsel mit der den normalen Betrieb anzeigenden LED-Farbe angezeigt wird.

6. Schaltgerät nach den Ansprüchen 1 bis 3, dadurch gekennzeichnet, daß zwischen dem einen Pol (19) der Versorgungsspannung und dem IC-Ausgang (22) zwei LED's (31', 35) hintereinandergeschaltet sind, wobei ein zwischen den LED's (31', 35) liegender Verteilerpunkt (37) mit dem einen Speisespannungs-Anschluß (21) und dem weiteren IC-Ausgang (30) verbunden ist, daß die direkt an den einen Pol (19) angeschlossene LED (31') den Betrieb des Schaltgerätes anzeigt, daß die direkt an den IC-Ausgang angeschlossene LED (35) den Schaltzustand anzeigt und daß ein Kurzschluß durch ein Pulsieren der auch den Betrieb anzeigenden LED (31') mit der Frequenz eines Taktgenerators (26) angezeigt wird.

7. Schaltgerät nach Anspruch 1, dadurch gekennzeichnet, daß zwischen dem einen Pol (19) der Versorgungsspannung und dem einen Speisespannungs-Anschluß (21) eine erste LED (34) als Betriebsanzeige geschaltet ist, daß eine zweite LED (31'') einerseits an den einen Pol (19) der Versorgungsspannung und andererseits an den IC-Ausgang (22) zur Anzeige des Schaltzustandes und an den weiteren IC-Ausgang (30) angeschlossen ist, so daß die zweite LED (31'') durch Blinken mit der Frequenz eines Taktgenerators (26) einen Kurzschlußfall anzeigt.

## Claims

1. Electronic, preferably contactlessly operating switching device, with a sensor (1) which can be influenced from the outside and of which the sensor signal is fed to an integrated circuit, also referred to as an IC, which comprises two line voltage terminals (20, 21) for connection to the two terminals (18, 19) of a supply voltage, an analyser stage (2), two push-pull driver stages (3, 4) for driving in each case an electronic power circuit breaker (10, 17), and a short-circuit scanning device (24) as a protection device, and which delivers a signal for the switching state of one of the power circuit breakers to an IC output (22) to which an LED (35) for the switching state can be connected directly, characterised in that the integrated circuit (IC) delivers to a further IC output (30) a pulsing signal for the display of a short circuit, to which a short-circuit display LED (31) can be connected directly, so that, while also using one (21) of the line voltage terminals (20, 21), the IC output (22) and the further IC output (30), the IC for the display of all states - "switching state," "short circuit" and "mode" - is selectively wired either with three LEDs (31, 34, 35) or with two LEDs (31', 31", 34, 35), wherein in the latter case the LED (31", 31') which can be connected to the further IC output displays either both the short circuit and the switching state simultaneously, or both the short circuit and the mode simultaneously.

2. Switching device according to claim 1, characterised in that the two driver stages (3, 4) are electrically uncoupled from each other, in that one (3) of the two driver stages (3, 4) internally to the IC is connected to both line voltage terminals (20, 21), in that the second driver stage (4) is connected to only one line voltage terminal (20) internally to the IC and can be connected to the supply voltage externally to the IC via the IC output (22) at which the signal for the switching state can be picked off.

3. Switching device according to claim 1 or 2, characterised in that the short-circuit scanning device (24) in case of a short circuit switches on a clock generator (26) which switches on the current source (28) of an LED driver (29) at a comparatively low frequency, as a result of which at the further IC output (30) a pulsing signal suitable for display of the case of short circuit is available.

4. Switching device according to claims 1 to 3, characterised in that between the further IC output (30) and one terminal (19) of the supply voltage is directly arranged an LED (31) as a short circuit display, in that between one terminal (19) and the IC output (22) two LEDs (34, 35) are connected in series, wherein a distributor point (36) located between the LEDs (34, 35) is connected to one line voltage terminal (21), and in that the LED (34) connected directly to one terminal (19) of the supply voltage displays the mode of the switching device and the LED (35) connected directly to the IC output (22) displays the switching state of the power circuit breaker (10).

5. Switching device according to claim 4, characterised in that the LED (31) displaying the short circuit and the LED (34) displaying the mode are combined in a double LED with common cathode or anode according to the line voltage polarity provided, so that a short circuit is displayed by a flashing secondary colour in alternation with the LED colour displaying the normal mode.

6. Switching device according to claims 1 to 3, characterised in that between one terminal (19) of the supply voltage and the IC output (22) two LEDs (31', 35) are connected in series, wherein a distributor point (37) located between the LEDs (31', 35) is connected to one line voltage terminal (21) and the further IC output (30), in that the LED (31') connected directly to one terminal (19) displays the mode of the switching device, in that the LED (35) connected directly to the IC output displays the switching state and in that a short circuit is displayed by pulsing of the LED (31') which also displays the mode, at the frequency of a clock generator (26).

7. Switching device according to claim 1, characterised in that between one terminal (19) of the supply voltage and one line voltage terminal (21) a first LED (34) is connected as a mode display, in that a second LED (31") is connected on the one hand to one terminal (19) of the supply voltage and on the other hand to the IC output (22) for display of the switching state and to the further IC output (30), so that the second LED (31") displays a case of short circuit by flashing at the frequency of a clock generator (26).

## Revendications

1. Dispositif électronique de commutation fonctionnant de préférence sans contact, avec un capteur (1) susceptible d'être influencé de l'extérieur, dont le signal de captage est transmis à un circuit intégré, appelé également CI, et qui présente deux bornes de tension d'alimentation (20, 21) pour raccordement aux deux pôles (18, 19) d'une tension d'alimentation, un étage d'identification (2), deux circuits de pilotage fonctionnant en opposition (3, 4) pour commander chacun un commutateur électronique de charge (10, 17), ainsi qu'un organe d'interrogation de court-circuit (24) en tant qu'organe de protection, et qui émet un signal concernant l'état de commutation de l'un des commutateurs de charge à une sortie (22) du circuit intégré, sur laquelle sortie une diode électroluminescente (35) pour l'état de commutation est susceptible d'être raccordée directement, caractérisé en ce que le circuit intégré (CI) émet à une sortie supplémentaire (30) du circuit intégré, un signal pulsé pour indiquer la présence d'un court-circuit, sur laquelle sortie une diode électroluminescente d'affichage de court-circuit (31) est susceptible d'être raccordée directement, de telle sorte qu'en utilisant une (21) des bornes de tension d'alimentation (20, 21), le circuit intégré qui est raccordé aux autres sorties du circuit intégré, soit mis sélectivement en circuit soit avec trois diodes électroluminescentes (31, 34, 35) soit avec deux diodes électroluminescentes (31', 31", 34, 35), de telle sorte que, dans ce dernier cas, les diodes électroluminescentes (31", 31') susceptibles d'être branchées sur les autres sorties du circuit intégré pour indiquer tous les états tels que "commutation", "court-circuit" et "en service", affichent soit le court-circuit ainsi que, simultanément, l'état de commutation, soit le court-circuit ainsi que, simultanément, l'état de fonctionnement.

2. Dispositif de commutation selon la revendication 1, caractérisé en ce que les deux étages de pilotage (3, 4) sont découplés électriquement, l'un par rapport à l'autre, en ce que l'un (3) des deux étages de pilotage (3, 4) sont reliés à l'intérieur du circuit intégré aux deux bornes de raccordement de la tension d'alimentation (20, 21), et en ce que le deuxième étage de pilotage (4) est relié à l'intérieur du circuit intégré uniquement à l'une des bornes de raccordement de la tension d'alimentation (20) en étant susceptible d'être relié à la tension d'alimentation, via la sortie (22) du circuit intégré sur laquelle est susceptible d'être prélevé le signal correspondant à l'état de commutation, de façon externe au circuit intégré.

3. Dispositif de commutation selon les revendications 1 ou 2, caractérisé en ce que l'organe d'interrogation de court-circuit (24), met en circuit, en cas d'un court-circuit, un générateur de rythme (26) qui met en circuit, à une fréquence relativement faible, la source de courant (28) d'un circuit de pilotage de diode électroluminescente (29), de telle sorte que, sur une sortie supplémentaire (30) du circuit intégré, soit disponible un signal cadencé approprié pour indiquer l'état de court-circuit.

4. Dispositif de commutation selon les revendications 1 à 3, caractérisé en ce que entre la sortie supplémentaire (30) du circuit intégré et l'un des pôles (19) de la tension d'alimentation, une diode électroluminescente (31) est disposée directement en tant qu'indicateur de court-circuit, en ce qu'entre l'un des pôles (19) et la sortie (22) du circuit intégré, deux diodes électroluminescentes (34, 35) sont reliées en série, un point de dérivation (36) disposé entre les diodes électroluminescentes (34, 35) étant relié à l'une des bornes de la tension d'alimentation (21), et en ce que la diode électroluminescente (34) qui est raccordée directement à l'un des pôles (19) de la tension d'alimentation, indique l'état de fonctionnement du dispositif de commutation, la diode électroluminescente (35) qui est raccordée directement à la sortie (22) du circuit intégré affichant l'état de commutation du commutateur de charge (10).

5. Dispositif de commutation selon la revendication 4, caractérisé en ce que la diode électroluminescente (31) d'affichage de court-circuit et la diode électroluminescente d'affichage de l'état de fonctionnement (34) sont réunies dans une double diode électroluminescente à cathode ou à anode commune, correspondant à la polarité de la tension d'alimentation prévue, de telle sorte qu'un court-circuit soit affiché par une couleur mélangée clignotante à partir de la couleur de la diode électroluminescente affichant l'état de fonctionnement normal.

6. Dispositif de commutation selon les revendications 1 à 3, caractérisé en ce que, entre l'un (19) des pôles de la tension d'alimentation et la sortie (22) du circuit intégré, deux diodes électroluminescentes (31', 35) sont raccordées en série, un point de dérivation (37) situé entre les diodes électroluminescentes (31', 35) étant relié à l'une des bornes (21) de la tension d'alimentation et à la sortie supplémentaire (30) du circuit intégré, et en ce que la diode électroluminescente (31') qui est raccordée directement à l'un des pôles (19) indique l'état de fonctionnement du dispositif de commutation, en ce que la diode électroluminescente (35) qui est raccordée directement à la sortie du circuit intégré indique l'état de commutation et en ce qu'un court-circuit est indiqué par une pulsation de la diode électroluminescente (31') qui affiche également l'état de fonctionnement, à la fréquence d'un générateur de rythme (26).

7. Dispositif de commutation selon la revendication 1, caractérisé en ce qu'entre l'un (19) des pôles de la tension d'alimentation et l'une (21) des bornes de la tension d'alimentation, une première diode électroluminescente (34) est raccordée en tant qu'indicateur de l'état de fonctionnement, en ce qu'une deuxième diode électroluminescente (31") est raccordée d'une part à l'un (19) des pôles de la tension d'alimentation et, d'autre part, à la sortie (22) du circuit intégré, ainsi qu'à la sortie supplémentaire (30) du circuit intégré, de telle sorte que la deuxième diode électroluminescente (31") indique, en clignotant à la fréquence d'un générateur de rythme (26), qu'un court-circuit s'est produit.
